# EUROPÄISCHE PATENTSCHRIFT

(11) **EP 4 233 498 B1**
(45) Veröffentlichungstag und Bekanntmachung des Hinweises auf die Patenterteilung: **23.10.2024**
(21) Anmeldenummer: 21786435.4
(22) Anmeldetag: 30.09.2021
(51) Int. Cl.: H05K 7/20, G01K 3/00, F04D 27/00, F04D 25/16, G01K 3/10, G01K 7/22

(54) **VERFAHREN UND VORRICHTUNG ZUM ÜBERWACHEN EINER LUFTKÜHLVORRICHTUNG**
METHOD AND DEVICE FOR MONITORING AN AIR COOLING DEVICE
PROCÉDÉ ET DISPOSITIF DE SURVEILLANCE D'UN DISPOSITIF DE REFROIDISSEMENT PAR AIR

(30) Priorität: 26.10.2020 DE 102020128059
(43) Veröffentlichungstag der Anmeldung: 30.08.2023
(73) Patentinhaber: Diehl AKO Stiftung & Co. KG, 88239 Wangen (DE)
(72) Erfinder: BIHLER, Simon, 88239 Wangen (DE)
(74) Vertreter: Diehl Patentabteilung
(86) Internationale Anmeldenummer: PCT/EP2021/077004
(87) Internationale Veröffentlichungsnummer: WO 2022/089871

(56) Entgegenhaltungen:
- EP-A1- 0 857 012
- EP-A2- 2 506 112
- EP-A2- 2 680 682
- DE-A1- 102012 218 190
- US-A1- 2002 145 853
- US-A1- 2013 107 905

## Beschreibung

### TECHNISCHER HINTERGRUND

Die vorliegende Erfindung betrifft ein Verfahren und eine Vorrichtung zum Überwachen einer Kühlleistung einer Luftkühlvorrichtung zum Kühlen eines elektrischen Bauteils einer Elektronikbaugruppe wie beispielsweise eines Wechselrichters einer Motorantriebsschaltung, wobei die Kühlvorrichtung einen mit dem elektrischen Bauteil thermisch gekoppelten Kühlkörper und einen Lüfter zum Erzeugen eines Kühlluftstroms über/durch den Kühlkörper aufweist.

Die durch Verlustleistung von elektronischen Komponenten auftretende Wärme wird meist über die Umgebungsluft gekühlt. Bei SMD (Surface Mounted Device) - Bauteilen erfolgt die Kühlung meist über die Leiterplatte mit entsprechenden Kupferflächen; bei THT (Through Hole Technology) - Bauteilen erfolgt die Kühlung bei verhältnismäßig geringer Verlustleistung nur mittels des eigenen Gehäuses und bei größerer Verlustleistung mit zusätzlich montierten Kühlkörpern. Reicht eine passive Kühlung (freie Konvektion) des Kühlkörpers nicht aus, kann zusätzlich eine aktive Kühlung (forcierte Konvektion) zum Beispiel über einen separaten Lüfter eingesetzt werden. Um die Kosten gering zu halten, werden dazu in der Regel einfache drehzahlkonstante Lüfter verwendet, die mit Gleichspannung betrieben werden, und die meist nicht über eine Rückmeldung der Drehzahl oder des Betriebszustands verfügen. Durch einen Fehler in der Spannungsversorgung des Lüfters, beispielsweise durch ein Bauteildefekt oder einen schlechten Übergangswiderstand am Steckkontakt, reduziert sich die Drehzahl oder fällt der Lüfter komplett aus. Ein Ausfall des Lüfters kann über die Lebensdauer auch aufgrund Verschmutzung oder sonstiger mechanischer Beschädigung auftreten. Ein Ausfall des Lüfters wird bei Anwendungen mit sehr hoher geforderter Lebensdauer als sehr wahrscheinlich angenommen werden, da die spezifizierte Lebensdauer solch einfacher Lüfter im Verhältnis zur Lebensdauer der Applikation meist geringer ist. Durch einen Ausfall des Lüfters wird die Kühlleistung stark reduziert, sodass die zu kühlenden Bauteile überhitzen, was zum Defekt der Elektronik und damit auch des Gesamtgeräts führen kann.

Um einen Defekt der gesamten Elektronik und somit einen Ausfall des Gesamtgerätes zu vermeiden, sind im Stand der Technik verschiedene Ansätze bekannt. Zum einen werden Schutzeinrichtungen für die zu kühlende Bauteile eingesetzt, sodass bei Erreichen eines oberen Temperaturlimits die Elektronik abschaltet. Hierzu werden Temperatursensoren in der Nähe platziert oder in den Bauteilen integriert. Dadurch kann zwar ein Defekt der Elektronik verhindert werden, allerdings führt dies zur Abschaltung der Elektronikfunktion und dadurch zum Ausfall des Gesamtgerätes. Ein anderer Ansatz basiert auf einer prädiktiven Methode. Bei bekannten Betriebsbedienungen und gleichbleibender Kühlung, muss die Temperatur in einem bekannten Bereich liegen. Wird dieser Bereich überschritten wird davon ausgegangen, dass die Kühlleistung abgenommen hat. Dadurch kann frühzeitig eine Reduzierung der Kühlleistung erkannt werden und gegebenenfalls durch einen Serviceeinsatz der Ausfall des Gesamtgerätes verhindert werden. Bei dieser Methode müssen zusätzlich die Umgebungstemperatur bekannt sein und auch eine gleichbleibende Verlustleistung vorhanden sein. Bei sich wechselnden Betriebszuständen ist diese Methode nicht umsetzbar.

Auf diese Weise kann zwar ein Defekt der Elektronik vermieden werden, um aber auch den Ausfall des Gesamtgerätes zu verhindern, muss auch ein Defekt einer Kühlvorrichtung erkannt und gemeldet werden können, sodass dieser Teil kurzfristig repariert werden kann. Ein bekanntes Verfahren zum Detektieren eines blockierten Lüfters basiert auf einer Messung der Stromversorgung des Lüfters. Dieses Verfahren ist bei einfachen Lüftern zur Überprüfung der prinzipiellen Funktion des Lüfters geeignet, kann aber lediglich die Funktion des Lüfters und nicht die Kühlwirkung erkennen. WO 2004/051090 A1 offenbart eine Vorrichtung zum Erzeugen eines Luftstroms zum Kühlen von elektrischen Bauteilen, die einen zusätzlichen Luftstromwächter zur Luftstrommessung aufweist, um den Lüftungsprozess zu überwachen. Die nachveröffentlichte DE 10 2019 004 070 A1 schlägt ein Verfahren zum Überwachen der tatsächlichen Kühlwirkung einer Luftkühlvorrichtung zum Kühlen eines elektrischen Bauteils einer Elektronikbaugruppe vor, bei dem die Kühlwirkung für das zu kühlende elektrische Bauteil basierend auf einem Betriebszustand der Elektronikbaugruppe und auf einer Temperaturdifferenz zwischen der Bauteiltemperatur und der Umgebungstemperatur oder einem Temperaturgradienten der Bauteiltemperatur ermittelt wird. DE 10 2012 218 190 A1 beschreibt ein Verfahren, bei dem die Temperatur der elektronischen Schaltung bei zumindest zwei verschiedenen Aktivitätszuständen, die beispielsweise durch eine Temperaturänderung mittels eines Heizelements generiert werden, erfasst und mit einem vorgegebenen Sollbereich verglichen wird, um bei einer Temperaturänderung außerhalb des Sollbereichs einen Alarm auszulösen.

Weitere Dokumente zum Stand der Technik sind
EP 2 680 682 A2, US 2002/145853 A1, EP 2 506 112 A2, EP 0 857 012 A1 und US 2013/107905 A1.

### ZUSAMMENFASSUNG DER ERFINDUNG

Es ist die Aufgabe der Erfindung, ein weiteres System zum Überwachen einer Kühlleistung einer einen Kühlkörper und einen Lüfter aufweisenden Luftkühlvorrichtung eines elektrischen Bauteils zu schaffen. Das erfindungsgemäße System soll dabei insbesondere einfach und kostengünstig ausgestaltet sein und ein zuverlässiges Überwachungsergebnis bereitstellen.

Diese Aufgabe wird gelöst durch den Gegenstand der unabhängigen Ansprüche. Besonders vorteilhafte Ausgestaltungen und Weiterbildungen der Erfindung sind Gegenstand der abhängigen Ansprüche.

Das erfindungsgemäße Verfahren zum Überwachen einer Kühlleistung einer Luftkühlvorrichtung zum Kühlen eines elektrischen Bauteils einer Elektronikbaugruppe, wobei die Kühlvorrichtung einen mit dem elektrischen Bauteil thermisch gekoppelten Kühlkörper und einen Lüfter zum Erzeugen eines Kühlluftstroms über/durch den Kühlkörper aufweist, enthält die Schritte des Aufheizens wenigstens eines Wärmeelements, das ein vom elektrischen Bauteil separates Element ist und in einem Bereich des Kühlluftstroms positioniert ist; des Ansteuerns des Lüfters zum Erhöhen der Kühlluftstromintensität; des Erfassens einer Temperatur des Wärmeelements; und des Ermittelns eines Defekts der Luftkühlvorrichtung in Abhängigkeit von der erfassten Temperatur des Wärmeelements nach der beabsichtigten erhöhten Kühlluftstromintensität.

Das erfindungsgemäße Überwachungsverfahren ist mit einfachen und kostengünstigen Komponenten zusätzlich zur Elektronikbaugruppe realisierbar und ermöglicht eine Überprüfung der tatsächlichen Kühlleistung der Luftkühlvorrichtung unabhängig vom Betriebszustand der Elektronikbaugruppe.

Das Verfahren ist anwendbar für Luftkühlvorrichtungen mit einem oder mehreren Kühlkörpern und mit einem oder mehreren Lüftern für einen Kühlkörper. Im Überwachungsverfahren können ein oder mehrere Wärmeelemente je Lüfter aufgeheizt und deren Temperatur(en) erfasst werden. Das Wärmeelement ist ein vom elektrischen Bauteil separates Element, wobei die Separation lokal und funktional zu verstehen ist. D.h. das Wärmeelement ist nicht in/an dem zu kühlenden elektrischen Bauteil integriert oder angebracht, vorzugsweise auch nicht innerhalb des Kühlkörpers angeordnet, und soll auch nicht den Betriebszustand des elektrischen Bauteils beeinflussen. Das Wärmeelement ist ein Element, dessen Temperatur durch äußere Einflüsse verändert werden kann, insbesondere durch die Umgebungstemperatur und durch entsprechende Heizkomponenten. In einer Ausführungsform der Erfindung ist das Wärmeelement beispielsweise als eine Kupferfläche ausgestaltet, die zum Beispiel mittels elektrischer Widerstände als Heizkomponenten erwärmt werden kann. Das Wärmeelement dient nicht dem direkten / indirekten Aufheizen anderer Komponenten, insbesondere nicht des elektrischen Bauteils der Elektronikbaugruppe und/oder des Kühlluftstroms, sondern wird nur selbst aufgeheizt. Das Erfassen der Temperatur des Wärmeelements kann durch einen Temperatursensor beispielsweise in Form eines NTC-Sensors erfolgen. Das Erfassen der Temperatur des Wärmeelements ist eine Temperaturerfassung direkt des Wärmeelements, d.h. nicht irgendeines anderen Elements, dessen Temperatur möglicherweise durch das aufgeheizte Wärmeelement zumindest etwas beeinflusst werden könnte. Das Ansteuern des Lüfters zum Erhöhen der Kühlluftstromintensität, das eine (vorzugsweise vorbestimmte) Zeitdauer nach dem Aufheizbeginn des Wärmeelements erfolgt, soll in diesem Zusammenhang abhängig vom Ausgangszustand des Lüfters zum Beispiel ein Einschalten des Lüfters oder eine Drehzahlerhöhung des Lüfters bedeuten. Optional kann der Lüfter zusätzlich vor oder nach dem Aufheizen des Wärmeelements zum Reduzieren der Kühlluftstromintensität angesteuert werden (d.h. ausgeschaltet werden oder Drehzahl verringern), bevor er zum Erhöhen der Kühlluftstromintensität angesteuert wird.

Das Wärmeelement befindet sich in einem Bereich des vom Lüfter erzeugten Kühlluftstroms, sodass es vom Kühlluftstrom überströmt oder durchströmt wird und eine Kühlluftstromintensität die Temperatur des Wärmeelements beeinflusst. Das Wärmeelement kann zu jeder Zeit, insbesondere unabhängig vom Betriebszustand des zu kühlenden elektrischen Bauteils, zusätzlich zu seinem aktuellen Zustand aufgewärmt werden. Um die Kühlleistung des Lüfters zu testen, wird das Wärmeelement erwärmt und wird anschließend die Intensität des Luftstroms beispielsweise durch Einschalten oder Drehzahlerhöhung des Lüfters erhöht, was zum Abkühlen des Wärmeelements und damit zum Absinken der erfassten Temperatur des Wärmeelements führt. Bleibt hingegen die erfasste Temperatur gleich oder steigt weiter an, kann daraus auf einen Defekt der Kühlvorrichtung (z.B. defekter Lüfter, verschmutztes oder verstopftes Lüftungssystem) geschlossen werden. Ein so ermittelter Defekt der Kühlvorrichtung kann dann vorzugsweise über eine Ausgabevorrichtung an einen Benutzer und/oder an eine Hauptsteuerung eines die Elektronikbaugruppe enthaltenden Geräts übermittelt werden, sodass entsprechende Aktionen wie beispielsweise ein Service-Einsatz eingeleitet werden kann, um die Kühlvorrichtung zu reparieren / wieder instand zu setzen, um die Funktionsfähigkeit des zu kühlenden elektrischen Bauteils und auch des Gesamtgerätes aufrechtzuerhalten.

In einer Ausgestaltung der Erfindung wird der Lüfter mehrfach abwechselnd zum Erhöhen und Erniedrigen der Kühlluftstromintensität angesteuert und wird ein Defekt der Luftkühlvorrichtung in Abhängigkeit von erfassten Temperaturen des Wärmeelements während der beabsichtigten variablen Kühlluftstromintensität ermittelt. Auf diese Weise können falsche Ermittlungsergebnisse und entsprechende Alarmhinweise aufgrund von zum Beispiel Fehlmessungen oder kurzzeitigen Störungen im Luftsystem verhindert werden, indem die mehreren Temperaturmessungen miteinander verglichen oder gemittelt werden.

In einer Ausgestaltung der Erfindung weist das Ermitteln eines Defekts der Luftkühlvorrichtung ein Vergleichen einer erfassten Temperaturdifferenz und/oder eines erfassten Temperaturgradienten des Wärmeelements zwischen Phasen unterschiedlicher beabsichtigter Kühlluftstromintensitäten mit einem vorbestimmten Schwellenwert auf.

Vorzugsweise wird im Überwachungsverfahren zusätzlich eine Umgebungstemperatur der Elektronikbaugruppe erfasst, sodass die Schritte des Aufheizens des Wärmeelements und/oder des Ermittelns eines Defekts der Luftkühlvorrichtung in Abhängigkeit von der erfassten Umgebungstemperatur ausgeführt werden können. Es besteht eine gewisse Abhängigkeit der Temperaturänderung des Wärmeelements von der aktuell vorhandenen Umgebungstemperatur, sodass bei niedrigeren Umgebungstemperaturen eine größere Änderung und bei hohen Umgebungstemperaturen eine geringere

Änderung zu erwarten ist. In Kenntnis der Umgebungstemperatur können zum Beispiel die Schwellenwerte für den Sollbereich einem etwas flacheren Verlauf der Temperaturänderung angepasst werden, um so mögliche Fehldetektionen zu vermeiden. Außerdem kann abhängig von der Umgebungstemperatur die Dauer des Tests angepasst werden, sodass bei höheren Umgebungstemperaturen die Aufwärmphase verlängert und dadurch ein größerer Temperaturanstieg erreicht werden können, wodurch eine präzisere Messung und geringeren Fehldetektionen erzielt werden können.

In einer Ausgestaltung der Erfindung werden die Schritte zum Überwachen der Kühlleistung der Luftkühlvorrichtung bevorzugt während eines Standby-Betriebszustandes des elektrischen Bauteils durchgeführt. Während des Standby muss die Luftkühlvorrichtung für die Überwachungsmessung nicht kurzfristig ausgeschaltet werden, da sie ohnehin nicht betrieben wird. Weiter ist in diesem Zeitraum die Temperaturmessung zuverlässiger, da die Umgebungsbedingungen während der Messung nicht durch die Verlustwärme der Elektronikbaugruppe beeinflusst werden und somit konstant bleiben. Wenn während des Standby-Betriebszustandes ein Defekt der Luftkühlvorrichtung erkannt wird, kann sofort ein Alarm ausgegeben werden, noch bevor die Elektronikbaugruppe bzw. das Gesamtgerät in Betrieb geht, sodass die Ausfallwahrscheinlichkeit des Gesamtgeräts verringert werden kann.

In einer bevorzugten Ausführungsform der Erfindung weist die Luftkühlvorrichtung mehrere (d.h. zwei oder mehr) Lüfter zum Erzeugen eines Kühlluftstroms über/durch den Kühlkörper auf, um eine redundante Luftkühlvorrichtung zu bilden. In diesem Fall wird jedem der mehreren Lüfter wenigstens ein eigenes Wärmeelement zugeordnet, sodass die Kühlleistungen der verschiedenen Lüfter unabhängig voneinander überwacht werden können. Bei dieser Ausführungsform werden die Schritte zum Überwachen der Kühlleistung der Luftkühlvorrichtung vorzugsweise nacheinander für die verschiedenen Lüfter mit ihren jeweiligen zugeordneten Wärmeelementen durchgeführt, um Defekte der Luftkühlvorrichtung bezogen auf einzelne der mehreren Lüfter zu ermitteln. Wenn diese Ermittlungsergebnisse an eine Steuerung des elektrischen Bauteils übermittelt werden, kann die Steuerung dann beim Betrieb des elektrischen Bauteils zum Kühlen des elektrischen Bauteils den als betriebsfähig ermittelten Lüfter ansteuern. Auf diese Weise kann die Elektronikbaugruppe selbst bei einer Fehlfunktion eines der mehreren Lüfter mit funktionierender Luftkühlung des elektrischen Bauteils weiter betrieben werden.

In einer weiteren Ausgestaltung der Erfindung weist das Überwachungsverfahren ferner Schritte des Speicherns der Messergebnisse der Temperatur und/oder der Temperaturdifferenz und/ oder des Temperaturgradienten des Wärmeelements und des Ermittelns eines voraussichtlich entstehenden Defekts der Luftkühlvorrichtung in Abhängigkeit von einer Veränderung der aktuellen Messergebnisse gegenüber den gespeicherten früheren Messergebnissen auf. Zum Beispiel kann mittels einer initialen Messung am Beginn der Lebensdauer, vorteilhafterweise während der Produktion der Elektronikbaugruppe, ein von der Umgebungstemperatur abhängiger Referenzwert bestimmt werden. Ferner können, falls sich die Kühlleistung im Verlauf der Lebensdauer aufgrund kontinuierlicher Zunahme der Verschmutzung mit einhergehend kontinuierlicher Abnahme der Kühlleistung reduziert und deshalb die Temperaturänderung beim Kühlen des Wärmeelements stetig geringer wird, die Messergebnisse vorteilhafterweise über einen bestimmten Zeitraum gemittelt werden, um einen Hinweis auf die Funktionsfähigkeit der Luftkühlvorrichtung zu geben. Steigt der ermittelte Wert über einen bestimmten Zeitraum überproportional an, kann dies ein Hinweis auf einen anstehenden Ausfall der Kühleinrichtung sein, sodass ein Alarmsignal zum Provozieren eines vorgezogenen oder zu frühen Serviceeinsatz ausgelöst werden kann, wodurch die Ausfallwahrscheinlichkeit des Gesamtgerätes weiter verringert werden kann.

Gemäß einem weiteren Aspekt der vorliegenden Erfindung weist eine Vorrichtung zum Überwachen einer Kühlleistung einer Luftkühlvorrichtung zum Kühlen eines elektrischen Bauteils einer Elektronikbaugruppe, wobei die Kühlvorrichtung einen mit dem elektrischen Bauteil thermisch gekoppelten Kühlkörper und einen Lüfter zum Erzeugen eines Kühlluftstroms über/durch den Kühlkörper aufweist, eine Überwachungseinheit mit wenigstens einem Wärmeelement, das ein vom elektrischen Bauteil separates Element ist und in einem Bereich des Kühlluftstroms positioniert ist, wenigstens einer Heizkomponente zum Aufheizen des wenigstens einen Wärmeelements; und wenigstens einem Temperatursensor zum Erfassen einer Temperatur des wenigstens einen Wärmeelements sowie eine Überwachungssteuerung, die mit der Überwachungseinheit und mit dem Lüfter verbunden ist, auf, wobei die Überwachungssteuerung konfiguriert ist, um das oben beschriebene Verfahren der Erfindung zum Überwachen der Kühlleistung der Luftkühlvorrichtung durchzuführen.

Mit dieser Vorrichtung können die gleichen Vorteile wie mit dem oben beschriebenen Überwachungsverfahren erzielt werden. Bezüglich der Vorteile, der bevorzugten Ausführungsformen und der Begriffsdefinitionen wird ergänzend auf die obigen Erläuterungen in Zusammenhang mit dem Überwachungsverfahren verwiesen.

Das wenigstens eine Wärmeelement der Überwachungseinheit ist vorzugsweise zwischen dem Lüfter und dem Kühlkörper positioniert. Bei dieser Positionierung des Wärmeelements wird das Wärmeelement mit der kälteren Umgebungstemperatur und nicht mit der durch die Verlustwärme des elektrischen Bauteils erhöhten Umgebungstemperatur gekühlt. Somit erfährt das Wärmeelement einen höheren Temperaturunterschied, wodurch die Temperaturerfassung und die Defektermittlung exakter werden.

Die Vorrichtung weist vorzugsweise ferner wenigstens einen Temperatursensor zum Erfassen einer Umgebungstemperatur der Elektronikbaugruppe auf, wobei dieser wenigstens eine Temperatursensor ebenfalls mit der Überwachungssteuerung verbunden ist.

In einer bevorzugten Ausführungsform der Erfindung weist die Luftkühlvorrichtung mehrere (d.h. zwei oder mehr) Lüfter zum Erzeugen eines Kühlluftstroms über/durch den Kühlkörper auf, um eine redundante Luftkühlvorrichtung zu bilden. In diesem Fall weist die Vorrichtung vorzugsweise für jeden der mehreren Lüfter eine eigene Überwachungseinheit auf, wobei die Überwachungssteuerung mit allen Überwachungseinheiten und mit allen Lüftern verbunden ist und konfiguriert ist, um die Schritte zum Überwachen der Kühlleistung der Luftkühlvorrichtung nacheinander für die verschiedenen Lüfter mit ihren jeweiligen zugeordneten Überwachungseinheiten durchzuführen, um Defekte der Luftkühlvorrichtung bezogen auf einzelne der mehreren Lüfter zu ermitteln.

In einer Ausgestaltung der Erfindung ist die Überwachungssteuerung mit einer Steuerung des elektrischen Bauteils verbunden oder kann mit dieser verbunden werden, um das Ermittlungsergebnis an diese Steuerung zu übermitteln, damit die Steuerung beim Betrieb des elektrischen Bauteils zum Kühlen des elektrischen Bauteils den betriebsfähig ermittelten Lüfter ansteuert. Die Steuerung des elektrischen Bauteils ist zum Beispiel eine Baugruppensteuerung der Elektronikbaugruppe und/oder eine Hauptsteuerung des Gesamtgeräts. Die Überwachungssteuerung kann wahlweise mit der Baugruppensteuerung gekoppelt sein oder zusammen mit der Baugruppensteuerung ein gemeinsames Steuerungselement bilden.

In einer weiteren Ausgestaltung der Erfindung kann die Überwachungssteuerung mit einer Ausgabevorrichtung und/oder einer Hauptsteuerung eines die Elektronikbaugruppe enthaltenden Geräts verbunden sein oder damit verbunden werden, um das Ermittlungsergebnis über die Ausgabevorrichtung optisch und/oder akustisch an einen Benutzer zu übermitteln und/oder an die Hauptsteuerung zu übermitteln.

Das oben beschriebene Überwachungsverfahren der Erfindung und die oben beschriebene Überwachungsvorrichtung der Erfindung können vorteilhafterweise für eine Antriebsschaltung (als Elektronikbaugruppe) mit einem Wechselrichter (als zu kühlendes elektrisches Bauteil) zum Antreiben eines elektronisch kommutierten Motors, zum Beispiel eines Motors für Kühlgeräte, Wärmepumpen, Schaltschränke und dergleichen, verwendet werden. Die vorliegende Erfindung ist aber auf keine spezielle Elektronikbaugruppe beschränkt.

### KURZBESCHREIBUNG DER ZEICHNUNGEN

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, größtenteils schematisch:
- Fig. 1: eine prinzipielle Darstellung einer Elektronikbaugruppe mit einer Luftkühlvorrichtung und einem Überwachungssystem gemäß einem Ausführungsbeispiel der Erfindung;
- Fig. 2: einen beispielhaften zeitlichen Verlauf einer Temperatur eines Wärmeelements über einen Messvorgang; und
- Fig. 3: einen beispielhaften zeitlichen Verlauf einer Temperatur eines Wärmeelements über einen Messvorgang mit mehrmaligem Ein- und Ausschalten des Lüfters.

### DETAILLIERTE BESCHREIBUNG DER ERFINDUNG

Der Gegenstand der Erfindung ist durch die angehängten Ansprüche definiert. Die nachfolgend erläuterten Ausführungsbeispiele sind nur beispielhaft und sollen den durch die Ansprüche definierten Schutzbereich nicht einschränken.

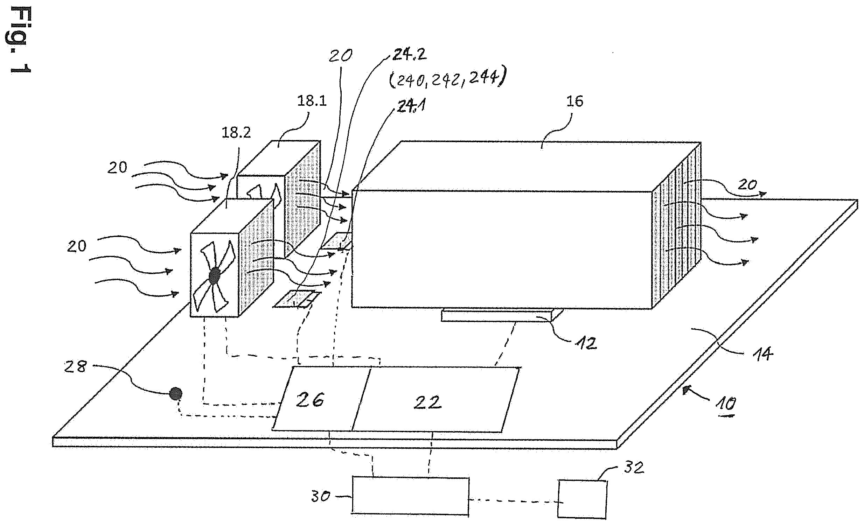

Fig. 1 zeigt beispielhaft eine Elektronikbaugruppe (z.B. Antriebsschaltung für einen Motor) 10, die ein zu kühlendes elektrisches Bauteil (zum Beispiel einen Wechselrichter) 12 auf einer Leiterplatte 14 aufweist.

Das elektrische Bauteil 12 wird durch eine Luftkühlvorrichtung gekühlt, die einen Kühlkörper 16 in thermischem Kontakt mit dem Bauteil 12 sowie wenigstens einen Lüfter 18 zum Erzeugen eines Kühlluftstroms 20 durch den Kühlkörper 16 aufweist. Die Lüfter 18.1, 18.2 ziehen die Umgebungsluft an und leiten diese forciert durch das Profil des Kühlkörpers 16. Im Ausführungsbeispiel von Fig. 1 werden zur Redundanz der Luftkühlvorrichtung zwei Lüfter 18.1 und 18.2 benutzt. Die Elektronikbaugruppe 10 enthält auch eine Baugruppensteuerung 22 zum Ansteuern des Bauteils 12. Die Baugruppensteuerung 22 ist auch mit den beiden Lüftern 18.1, 18.2, gekoppelt, um diese ein- und ausschalten zu können und optional auch ihre Drehzahlen einzustellen.

Zum Überwachen der tatsächlichen Kühlleistung der Luftkühlvorrichtung ist jedem Lüfter 18.1, 18.2 eine Überwachungseinheit 24.1, 24.2 zugeordnet. Die Überwachungseinheiten 24.1, 24.2 befinden sich in diesem Ausführungsbeispiel zwischen dem jeweiligen Lüfter 18.1, 18.2 und dem Kühlkörper 16 im Bereich des Kühlluftstroms 20. Die beiden Überwachungseinheiten 24.1, 24.2 weisen jeweils wenigstens ein Wärmeelement 240 zum Beispiel in Form einer Kupferfläche auf der Leiterplatte 14, wenigstens einen Temperatursensor 242 zum Beispiel in Form eines NTC-Sensors zum Erfassen einer Temperatur des Wärmeelements 240 und wenigstens eine Heizkomponente 244 zum Beispiel in Form eines elektrischen Widerstandes zum Aufwärmen des Wärmeelements 240 auf. Die Überwachungseinheiten 24.1, 24.2 sind mit einer Überwachungssteuerung 26 verbunden, welche die Heizkomponenten 244 ansteuert und an welche die Messergebnisse der Temperaturerfassung übermittelt werden. Die Überwachungssteuerung 26 ist außerdem mit den Lüftern 18.1, 18.2 verbunden, um diese unabhängig vom Betriebszustand des Bauteils 12 anzusteuern (ein- und ausschalten und/oder Drehzahl verändern). Die Überwachungssteuerung 26 enthält vorzugsweise auch einen Speicher zum Speichern der Messergebnisse und einen Timer zum Terminieren der Ansteuerung der Heizkomponenten 244 und der Lüfter 18.

Wie in Fig. 1 dargestellt, ist ferner ein Temperatursensor 28 zum Erfassen der Umgebungstemperatur der Elektronikbaugruppe 10 vorgesehen. Der Temperatursensor 28 ist ebenfalls mit der Überwachungssteuerung 26 verbunden, sodass diese die Ansteuerung der Heizkomponenten 244 und die Auswertung der Messergebnisse der Temperatur des Wärmeelements auch abhängig von der Umgebungstemperatur ausführen kann.

Wie ferner in Fig. 1 dargestellt, sind die Überwachungssteuerung 26 und die Baugruppensteuerung 22 miteinander verbunden oder sogar als ein gemeinsames Steuerelement ausgestaltet. Außerdem sind die beiden Steuerungen 22, 26 mit einer Hauptsteuerung 30 des Gesamtgerätes verbunden, um Messdaten und Steuerbefehle auszutauschen. Außerdem sind die beiden Steuerungen 22, 26 direkt oder über die Hauptsteuerung 30 mit einer Ausgabevorrichtung 32 verbunden, über die zum Beispiel Betriebszustandsinformationen und Alarmsignale an einen Benutzer ausgegeben werden können.

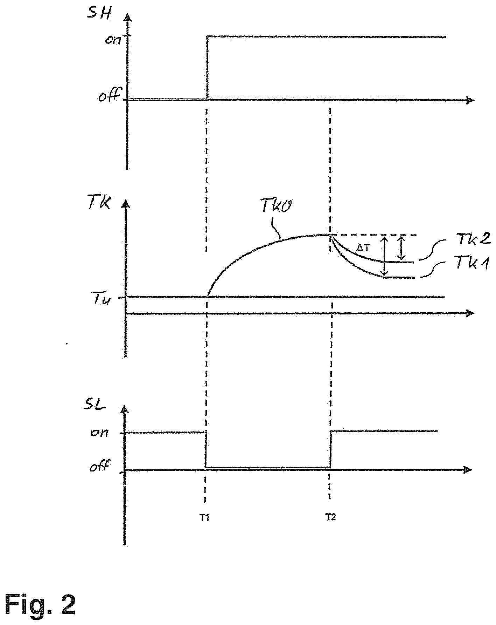

Fig. 2 veranschaulicht beispielhaft den zeitlichen Verlauf eines einmaligen Messvorgangs durch eine Überwachungseinheit 24 für die Fehlererkennung eines Lüfters 18. Das untere Zeitdiagramm zeigt den Status des Lüfters SL mit den zwei Zuständen eingeschaltet ("on") und ausgeschaltet ("off). Das obere Zeitdiagramm zeigt den Status der Heizkomponente SH mit den zwei Zuständen eingeschaltet zum Aufwärmen des Wärmeelements ("on") und ausgeschaltet ("off). Das mittlere Zeitdiagramm zeigt den Verlauf der Temperatur Tk des Wärmeelements 240.

Zum Start des Überwachungsvorgangs wird der Lüfter 18 zum Zeitpunkt T1 ausgeschaltet und beginnt gleichzeitig das Aufheizen des Wärmeelements 240 in der Überwachungseinheit 24. Der Start des Aufheizens kann allerdings auch unabhängig zum Ausschaltvorgang des Lüfters 18 durchgeführt werden. Zum Zeitpunkt T2 wird dann der Lüfter 18 eingeschaltet. Zum Zeitpunkt T2 muss sich die Temperatur am NTC-Sensor nicht in einem eingeschwungenen Zustand befinden, die Zeitdauer zwischen T1 und T2 sollte aber lang genug sein, damit der NTC-Sensor einen wesentlichen Temperaturanstieg erfährt.

Wie aus dem mittleren Zeitdiagramm von Fig. 2 ersichtlich, steigt die Temperatur Tk des Wärmeelements 240 während des ausgeschalteten Lüfters 18 und während des Aufheizens des Wärmeelements ausgehend von der Umgebungstemperatur Tu kontinuierlich an. Der Linienabschnitt Tk0 zeigt die Temperatur des Wärmeelements ohne Kühlleistung des Lüfters. Wenn dann zum Zeitpunkt T2 der Lüfter 18 wieder eingeschaltet wird, sinkt die vom NTC-Sensor 242 erfasste Temperatur Tk des Wärmeelements 240 abhängig von der Kühlleitung der Luftkühlvorrichtung. Der Linienabschnitt Tk1 zeigt einen Temperaturverlauf des Wärmeelements bei normaler Kühlleistung des Lüfters, der Linienabschnitt Tk2 zeigt einen Temperaturverlauf des Wärmeelements bei reduzierter Kühlleistung des Lüfters. In Fig. 2 sind auch die entsprechenden Temperaturdifferenzen ΔT zwischen Tk0 und Tk1 bzw. Tk2 gezeigt. Die erfasste Temperaturdifferenz ΔT wird von der Überwachungssteuerung 26 mit einem vorgegebenen Schwellenwert verglichen, um zu beurteilen, ob die Kühlleistung im erforderlichen Rahmen liegt oder ob ein Defekt der Luftkühlvorrichtung existiert.

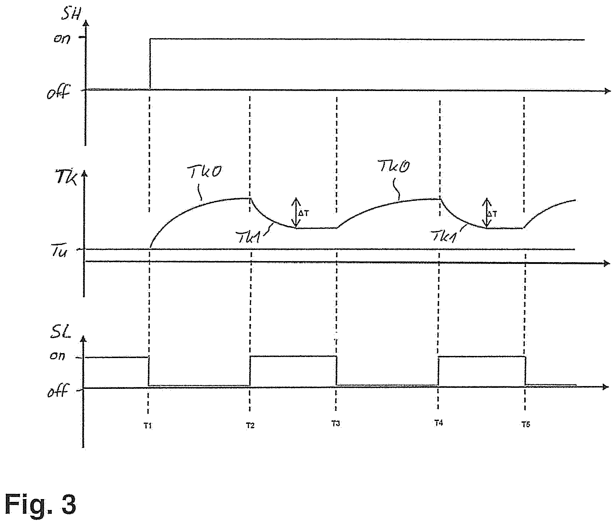

Fig. 3 veranschaulicht beispielhaft den zeitlichen Verlauf eines Messvorgangs durch eine Überwachungseinheit 24 für die Fehlererkennung eines Lüfters 18 mit einem mehrmaligen Ein- und Ausschalten des Lüfters 18. Das untere Zeitdiagramm zeigt den Status des Lüfters SL mit den zwei Zuständen eingeschaltet ("on") und ausgeschaltet ("off); das obere Zeitdiagramm zeigt den Status der Heizkomponente SH mit den zwei Zuständen eingeschaltet zum Aufwärmen des Wärmeelements ("on") und ausgeschaltet ("off); und das mittlere Zeitdiagramm zeigt den Verlauf der Temperatur Tk des Wärmeelements 240.

Der Überwachungsvorgang von Fig. 3 ist grundsätzlich analog zu dem von Fig. 2. Im Vergleich zu Fig. 2 wird zusätzlich innerhalb der Aufheizphase des Wärmeelements 240 ab dem Zeitpunkt T1 der Lüfter 18 mehrmals eingeschaltet (T2, T4) und ausgeschaltet (T3, T5). Dadurch kann beispielsweise über eine Mittelung mehrerer erfasster Temperaturdifferenzen ΔT eine fehlertolerantere Erkennung eines Defekts des Lüfters 18 erreicht werden.

Alternativ oder zusätzlich zur Auswertung der Temperaturdifferenzen können auch die Temperaturgradienten der Temperaturverläufe ausgewertet werden.

Die in Fig. 2 und 3 veranschaulichten Messvorgänge können nacheinander für die verschiedenen Lüfter 18.1, 18.2 durchgeführt werden, um die Kühlleistungen der Lüfter unabhängig voneinander ermitteln zu können. Wird bei einem der Lüfter ein Defekt ermittelt, so kann die Elektronikbaugruppe 10 noch unter Verwendung des anderen Lüfters, der als betriebsfähig ermittelt worden ist, weiter betrieben werden. Die beiden Lüfter 18.1, 18.2 bilden so eine Redundanz der Kühlleistung, um den Betriebsausfall der Elektronikbaugruppe 10 zu vermeiden.

### BEZUGSZI FFERN LISTE

- 10: Elektronikbaugruppe
- 12: elektrisches Bauteil
- 14: Leiterplatte
- 16: Kühlkörper
- 18, 18.1, 18.2: Lüfter
- 20: Kühlluftstrom
- 22: Baugruppensteuerung
- 24, 24.1, 24.2: Überwachungseinheit
- 240: Wärmeelement
- 242: Temperatursensor
- 244: Heizkomponente
- 26: Überwachungssteuerung
- 28: Temperatursensor
- 30: Hauptsteuerung
- 32: Ausgabevorrichtung

- SH: Status der Heizkomponente(n)
- SL: Status des Lüfters
- Tk: Temperatur des Wärmeelements
- Tk0: Temperatur des Wärmeelements ohne Kühlleistung
- Tk1: Temperatur des Wärmeelements bei normaler Kühlleistung
- Tk2: Temperatur des Wärmeelements bei reduzierter Kühlleistung
- ΔT: Temperaturdifferenz zwischen mit und ohne Kühlleistung
- Tu: Umgebungstemperatur

## Patentansprüche

1. Verfahren zum Überwachen einer Kühlleistung einer Luftkühlvorrichtung zum Kühlen eines elektrischen Bauteils (12) einer Elektronikbaugruppe (10), wobei die Kühlvorrichtung einen mit dem elektrischen Bauteil (12) thermisch gekoppelten Kühlkörper (16) und einen Lüfter (18) zum Erzeugen eines Kühlluftstroms (20) über/durch den Kühlkörper (16) aufweist, aufweisend:
Aufheizen eines Wärmeelements (240), das ein vom elektrischen Bauteil (12) separates Element ist und in einem Bereich des Kühlluftstroms (20) positioniert ist;
Ansteuern des Lüfters (18) zum Erhöhen der Kühlluftstromintensität;
Erfassen einer Temperatur (Tk) des Wärmeelements (240); und
Ermitteln eines Defekts der Luftkühlvorrichtung in Abhängigkeit von der erfassten Temperatur (Tk) des Wärmeelements (240) nach der beabsichtigten erhöhten Kühlluftstromintensität.

2. Verfahren nach Anspruch 1, bei welchem der Lüfter (18) mehrfach abwechselnd zum Erhöhen und Erniedrigen der Kühlluftstromintensität angesteuert wird und ein Defekt der Luftkühlvorrichtung in Abhängigkeit von erfassten Temperaturen (Tk) des Wärmeelements (240) während der beabsichtigten variablen Kühlluftstromintensität ermittelt wird.

3. Verfahren nach Anspruch 1 oder 2, bei welchem das Ermitteln eines Defekts der Luftkühlvorrichtung ein Vergleichen einer erfassten Temperaturdifferenz (ΔT) und/ oder eines erfassten Temperaturgradienten des Wärmeelements (240) zwischen Phasen unterschiedlicher beabsichtigter Kühlluftstromintensitäten mit einem vorbestimmten Schwellenwert aufweist.

4. Verfahren nach einem der vorhergehenden Ansprüche, bei welchem zusätzlich eine Umgebungstemperatur (Tu) der Elektronikbaugruppe (10) erfasst wird und die Schritte des Aufheizens des Wärmeelements (240) und/oder des Ermittelns eines Defekts der Luftkühlvorrichtung in Abhängigkeit von der erfassten Umgebungstemperatur (Tu) ausgeführt werden.

5. Verfahren nach einem der vorhergehenden Ansprüche, bei welchem die Schritte zum Überwachen der Kühlleistung der Luftkühlvorrichtung während eines Standby-Betriebszustandes des elektrischen Bauteils (12) durchgeführt werden.

6. Verfahren nach einem der vorhergehenden Ansprüche, bei welchem
die Luftkühlvorrichtung mehrere Lüfter (18.1, 18.2) zum Erzeugen eines Kühlluftstroms (20) über/durch den Kühlkörper (16) aufweist und jedem der mehreren Lüfter (18.1, 18.2) ein Wärmeelement (240) zugeordnet ist; und
die Schritte zum Überwachen der Kühlleistung der Luftkühlvorrichtung nacheinander für die verschiedenen Lüfter (18.1, 18.2) mit ihren jeweiligen zugeordneten Wärmeelementen (240) durchgeführt werden, um Defekte der Luftkühlvorrichtung bezogen auf einzelne der mehreren Lüfter (18.1, 18.2) zu ermitteln.

7. Verfahren nach Anspruch 6, bei welchem das Ermittlungsergebnis an eine Steuerung (22, 30) des elektrischen Bauteils (12) übermittelt wird, damit die Steuerung (22, 30) beim Betrieb des elektrischen Bauteils (12) zum Kühlen des elektrischen Bauteils (12) einen betriebsfähigen Lüfter (18.1, 18.2) ansteuert.

8. Verfahren nach einem der vorhergehenden Ansprüche, ferner aufweisend:
Speichern der Messergebnisse der Temperatur (Tk) und/oder der Temperaturdifferenz (ΔT) und/ oder des Temperaturgradienten des Wärmeelements (240); und
Ermitteln eines voraussichtlich entstehenden Defekts der Luftkühlvorrichtung in Abhängigkeit von einer Veränderung der aktuellen Messergebnisse gegenüber den gespeicherten früheren Messergebnissen.

9. Vorrichtung zum Überwachen einer Kühlleistung einer Luftkühlvorrichtung zum Kühlen eines elektrischen Bauteils (12) einer Elektronikbaugruppe (10), wobei die Kühlvorrichtung einen mit dem elektrischen Bauteil (12) thermisch gekoppelten Kühlkörper (16) und einen Lüfter (18) zum Erzeugen eines Kühlluftstroms (20) über/durch den Kühlkörper (16) aufweist, aufweisend:
eine Überwachungseinheit (24), aufweisend:
wenigstens ein Wärmeelement (240), das ein vom elektrischen Bauteil (12) separates Element ist und in einem Bereich des Kühlluftstroms (20) positioniert ist;
wenigstens eine Heizkomponente (244) zum Aufheizen des wenigstens einen Wärmeelements (240); und
wenigstens einen Temperatursensor (242) zum Erfassen einer Temperatur (Tk) des wenigstens einen Wärmeelements (240); und
eine Überwachungssteuerung (26), die mit der Überwachungseinheit (24) und mit dem Lüfter (18) verbunden ist, wobei die Überwachungssteuerung konfiguriert ist,
um das Verfahren zum Überwachen der Kühlleistung der Luftkühlvorrichtung nach einem der Ansprüche 1 bis 8 durchzuführen.

10. Vorrichtung nach Anspruch 9, bei welcher das wenigstens eine Wärmeelement (240) der Überwachungseinheit (24) zwischen dem Lüfter (18) und dem Kühlkörper (16) positioniert ist.

11. Vorrichtung nach Anspruch 9 oder 10, ferner aufweisend wenigstens einen Temperatursensor (28) zum Erfassen einer Umgebungstemperatur (Tu) der Elektronikbaugruppe (10), wobei der wenigstens eine Temperatursensor (28) mit der Überwachungssteuerung (26) verbunden ist.

12. Vorrichtung nach einem der Ansprüche 9 bis 11, bei welcher
die Luftkühlvorrichtung mehrere Lüfter (18.1, 18.2) zum Erzeugen eines Kühlluftstroms (20) über/durch den Kühlkörper (16) aufweist;
die Vorrichtung für jeden der mehreren Lüfter (18.1, 18.2) eine Überwachungseinheit (24.1, 24.2) aufweist; und
die Überwachungssteuerung (26) mit allen Überwachungseinheiten (24.1, 24.2) und mit allen Lüftern (18.1, 18.2) verbunden ist und konfiguriert ist, um die Schritte zum Überwachen der Kühlleistung der Luftkühlvorrichtung nacheinander für die verschiedenen Lüfter (18.1, 18.2) mit ihren jeweiligen zugeordneten Überwachungseinheiten (24.1, 24.2) durchzuführen, um Defekte der Luftkühlvorrichtung bezogen auf einzelne der mehreren Lüfter (18.1, 18.2) zu ermitteln.

13. Vorrichtung nach Anspruch 12, bei welcher die Überwachungssteuerung (26) mit einer Steuerung (22, 30) des elektrischen Bauteils (12) verbunden ist oder verbunden werden kann, um das Ermittlungsergebnis an diese Steuerung (22, 30) zu übermitteln, damit die Steuerung (22, 30) beim Betrieb des elektrischen Bauteils (12) zum Kühlen des elektrischen Bauteils (12) einen betriebsfähigen Lüfter (18.1, 18.2) ansteuert.

14. Vorrichtung nach einem der Ansprüche 9 bis 13, bei welcher die Überwachungssteuerung (26) mit einer Ausgabevorrichtung (32) und/oder einer Hauptsteuerung (30) eines die Elektronikbaugruppe (10) enthaltenden Geräts verbunden ist oder verbunden werden kann, um das Ermittlungsergebnis über die Ausgabevorrichtung (32) an einen Benutzer zu übermitteln und/oder an die Hauptsteuerung (30) zu übermitteln.

15. Verwendung des Verfahrens nach einem der Ansprüche 1 bis 8 oder der Vorrichtung nach einem der Ansprüche 9 bis 14 für eine Antriebsschaltung mit einem Wechselrichter zum Antreiben eines elektronisch kommutierten Motors.

## Claims

1. Method for monitoring a cooling power of an air cooling device for cooling an electrical component (12) of an electronics assembly (10), the cooling device comprising a heat sink (16), which is thermally coupled to the electrical component (12), and a fan (18) for generating a cooling air flow (20) over/through the heat sink (16), the method comprising:
heating a thermal element (240), which is an element separate from the electrical component (12) and is positioned in a region of the cooling air flow (20);
actuating the fan (18) in order to increase the cooling air flow intensity;
detecting a temperature (Tk) of the thermal element (240); and
ascertaining a defect of the air cooling device depending on the detected temperature (Tk) of the thermal element (240) following the intended increased cooling air flow intensity.

2. Method according to Claim 1, wherein the fan (18) is repeatedly actuated alternately in order to increase and decrease the cooling air flow intensity and a defect of the air cooling device is ascertained depending on detected temperatures (Tk) of the thermal element (240) during the intended variable cooling air flow intensity.

3. Method according to Claim 1 or 2, wherein ascertaining a defect of the air cooling device comprises comparing a detected temperature difference (ΔT) and/or a detected temperature gradient of the thermal element (240) between phases of different intended cooling air flow intensities with a predetermined threshold value.

4. Method according to any of the preceding claims, wherein additionally an ambient temperature (Tu) of the electronics assembly (10) is detected and the steps of heating the thermal element (240) and/or ascertaining a defect of the air cooling device are carried out depending on the detected ambient temperature (Tu).

5. Method according to any of the preceding claims, wherein the steps for monitoring the cooling power of the air cooling device are carried out during a standby operating state of the electrical component (12).

6. Method according to any of the preceding claims, wherein
the air cooling device comprises a plurality of fans (18.1, 18.2) for generating a cooling air flow (20) over/through the heat sink (16) and each of the plurality of fans (18.1, 18.2) is assigned a thermal element (240); and
the steps for monitoring the cooling power of the air cooling device are carried out successively for the different fans (18.1, 18.2) with their respective assigned thermal elements (240) in order to ascertain defects of the air cooling device relative to individual fans from the plurality of fans (18.1, 18.2).

7. Method according to Claim 6, wherein the ascertaining result is communicated to a controller (22, 30) of the electrical component (12) in order that the controller (22, 30) actuates an operational fan (18.1, 18.2) during operation of the electrical component (12) for the purpose of cooling the electrical component (12).

8. Method according to any of the preceding claims, furthermore comprising:
storing the measurement results pertaining to the temperature (Tk) and/or the temperature difference (ΔT) and/or the temperature gradient of the thermal element (240); and
ascertaining a defect anticipated to arise in the air cooling device depending on a change in the current measurement results vis-à-vis the stored earlier measurement results.

9. Device for monitoring a cooling power of an air cooling device for cooling an electrical component (12) of an electronics assembly (10), the cooling device comprising a heat sink (16), which is thermally coupled to the electrical component (12), and a fan (18) for generating a cooling air flow (20) over/through the heat sink (16), the device comprising:
a monitoring unit (24), comprising:
at least one thermal element (240), which is an element separate from the electrical component (12) and is positioned in a region of the cooling air flow (20);
at least one heating component (244) for heating the at least one thermal element (240); and
at least one temperature sensor (242) for detecting a temperature (Tk) of the at least one thermal element (240); and
a monitoring controller (26), which is connected to the monitoring unit (24) and to the fan (18), the monitoring controller being configured to carry out the method for monitoring the cooling power of the air cooling device according to any of Claims 1 to 8.

10. Device according to Claim 9, wherein the at least one thermal element (240) of the monitoring unit (24) is positioned between the fan (18) and the heat sink (16).

11. Device according to Claim 9 or 10, furthermore comprising at least one temperature sensor (28) for detecting an ambient temperature (Tu) of the electronics assembly (10), the at least one temperature sensor (28) being connected to the monitoring controller (26).

12. Device according to any of Claims 9 to 11, wherein the air cooling device comprises a plurality of fans (18.1, 18.2) for generating a cooling air flow (20) over/through the heat sink (16);
the device comprises a monitoring unit (24.1, 24.2) for each of the plurality of fans (18.1, 18.2); and
the monitoring controller (26) is connected to all the monitoring units (24.1, 24.2) and to all the fans (18.1, 18.2) and is configured to carry out the steps for monitoring the cooling power of the air cooling device successively for the different fans (18.1, 18.2) with their respective assigned monitoring units (24.1, 24.2) in order to ascertain defects of the air cooling device relative to individual fans from the plurality of fans (18.1, 18.2).

13. Device according to Claim 12, wherein the monitoring controller (26) is connected or can be connected to a controller (22, 30) of the electrical component (12) in order to communicate the ascertaining result to this controller (22, 30) in order that the controller (22, 30) actuates an operational fan (18.1, 18.2) during operation of the electrical component (12) for the purpose of cooling the electrical component (12).

14. Device according to any of Claims 9 to 13, wherein the monitoring controller (26) is connected or can be connected to an output device (32) and/or a main controller (30) of an apparatus containing the electronics assembly (10), in order to communicate the ascertaining result via the output device (32) to a user and/or to communicate it to the main controller (30).

15. Use of the method according to any of Claims 1 to 8 or of the device according to any of Claims 9 to 14 for a drive circuit with an inverter for driving an electronically commutated motor.

## Revendications

1. Procédé permettant de surveiller une puissance de refroidissement d'un dispositif de refroidissement par air destiné à refroidir un composant électrique (12) d'un ensemble électronique (10), dans lequel le dispositif de refroidissement présente un dissipateur thermique (16) thermiquement couplé au composant électrique (12), et une soufflante (18) pour produire un flux d'air de refroidissement (20) sur/à travers le dissipateur thermique (16), présentant les étapes consistant à :
chauffer un élément thermique (240) qui est un élément séparé du composant électrique (12) et est positionné dans une zone du flux d'air de refroidissement (20) ;
piloter la soufflante (18) pour augmenter l'intensité de flux d'air de refroidissement ;
détecter une température (Tk) de l'élément thermique (240) ; et
déterminer un défaut du dispositif de refroidissement par air en fonction de la température (Tk) détectée de l'élément thermique (240) selon l'intensité de flux d'air de refroidissement augmentée prévue.

2. Procédé selon la revendication 1, dans lequel la soufflante (18) est pilotée à plusieurs reprises en alternance pour augmenter et diminuer l'intensité de flux d'air de refroidissement, et un défaut du dispositif de refroidissement par air est déterminé en fonction des températures détectées (Tk) de l'élément thermique (240) pendant l'intensité de flux d'air de refroidissement variable prévue.

3. Procédé selon la revendication 1 ou 2, dans lequel la détermination d'un défaut du dispositif de refroidissement par air présente une comparaison d'une différence de température détectée (ΔT) et/ou d'un gradient de température détecté de l'élément thermique (240) entre des phases de différentes intensités de flux d'air de refroidissement prévues avec une valeur seuil prédéterminée.

4. Procédé selon l'une quelconque des revendications précédentes, dans lequel de plus une température ambiante (Tu) de l'ensemble électronique (10) est détectée, et les étapes de chauffage de l'élément thermique (240) et/ou de la détermination d'un défaut du dispositif de refroidissement par air sont effectuées en fonction de la température ambiante détectée (Tu).

5. Procédé selon l'une quelconque des revendications précédentes, dans lequel les étapes de surveillance de la puissance de refroidissement du dispositif de refroidissement par air sont effectuées pendant un état de fonctionnement de veille du composant électrique (12) .

6. Procédé selon l'une quelconque des revendications précédentes, dans lequel
le dispositif de refroidissement par air présente plusieurs soufflantes (18.1, 18.2) pour produire un flux d'air de refroidissement (20) sur/à travers le dissipateur thermique (16), et un élément thermique (240) est associé à chacune des plusieurs soufflantes (18.1, 18.2) ; et
les étapes de surveillance de la puissance de refroidissement du dispositif de refroidissement par air sont effectuées les unes après les autres pour les différentes soufflantes (18.1, 18.2) avec leurs éléments thermiques (240) associés respectifs pour déterminer des défauts du dispositif de refroidissement par air par rapport à certaines des plusieurs soufflantes (18.1, 18.2).

7. Procédé selon la revendication 6, dans lequel le résultat de la détermination est transmis à un dispositif de commande (22, 30) du composant électrique (12) pour que le dispositif de commande (22, 30) lors du fonctionnement du composant électrique (12) pilote une soufflante opérationnelle (18.1, 18.2) pour refroidir le composant électrique (12).

8. Procédé selon l'une quelconque des revendications précédentes, présentant en outre les étapes consistant à :
stocker les résultats de mesure de la température (Tk) et/ou de la différence de température (ΔT) et/ou du gradient de température de l'élément thermique (240) ; et
déterminer un défaut probablement imminent du dispositif de refroidissement par air en fonction d'une variation des résultats de mesure actuels par rapport aux résultats de mesure antérieurs stockés.

9. Dispositif permettant de surveiller une puissance de refroidissement d'un dispositif de refroidissement par air pour refroidir un composant électrique (12) d'un ensemble électronique (10), dans lequel le dispositif de refroidissement présente un dissipateur thermique (16) couplé thermiquement au composant électrique (12) et une soufflante (18) pour produire un flux d'air de refroidissement (20) sur/à travers le dissipateur thermique (16), présentant :
une unité de surveillance (24), présentant :
au moins un élément thermique (240) qui est un élément séparé du composant électrique (12) et est positionné dans une zone du flux d'air de refroidissement (20) ;
au moins un composant chauffant (244) pour chauffer ledit au moins un élément thermique (240) ; et
au moins un capteur de température (242) pour détecter une température (Tk) dudit au moins un élément thermique (240) ; et
un dispositif de commande de surveillance (26) qui est relié à l'unité de surveillance (24) et à la soufflante (18), dans lequel le dispositif de commande de surveillance est configuré pour exécuter le procédé permettant de surveiller la puissance de refroidissement du dispositif de refroidissement par air selon l'une quelconque des revendications 1 à 8.

10. Dispositif selon la revendication 9, dans lequel ledit au moins un élément thermique (240) de l'unité de surveillance (24) est positionné entre la soufflante (18) et le dissipateur thermique (16).

11. Dispositif selon la revendication 9 ou 10, présentant en outre au moins un capteur de température (28) pour détecter une température ambiante (Tu) de l'ensemble électronique (10), dans lequel ledit au moins un capteur de température (28) est relié au dispositif de commande de surveillance (26).

12. Dispositif selon l'une quelconque des revendications 9 à 11, dans lequel
le dispositif de refroidissement par air présente plusieurs soufflantes (18.1, 18.2) pour produire un flux d'air de refroidissement (20) sur/à travers le dissipateur thermique (16) ;
le dispositif présente une unité de surveillance (24.1, 24.2) pour chacune des plusieurs soufflantes (18.1, 18.2) ; et
le dispositif de commande de surveillance (26) est relié à toutes les unités de surveillance (24.1, 24.2) et à toutes les soufflantes (18.1, 18.2) et est configuré pour effectuer les étapes de surveillance de la puissance de refroidissement du dispositif de refroidissement par air les unes après les autres pour les différentes soufflantes (18.1, 18.2) avec leurs unités de surveillance (24.1, 24.2) respectivement associées afin de déterminer des défauts du dispositif de refroidissement par air par rapport à certaines des plusieurs soufflantes (18.1, 18.2).

13. Dispositif selon la revendication 12, dans lequel le dispositif de commande de surveillance (26) est relié ou peut être relié à un dispositif de commande (22, 30) du composant électronique (12) pour transmettre le résultat de la détermination à ce dispositif de commande (22, 30) pour que le dispositif de commande (22, 30) pilote en cours de fonctionnement du composant électrique (12) une soufflante opérationnelle (18.1, 18.2) pour refroidir le composant électrique (12).

14. Dispositif selon l'une quelconque des revendications 9 à 13, dans lequel le dispositif de commande de surveillance (26) est relié ou peut être relié à un dispositif de sortie (32) et/ou à un dispositif de commande principal (30) d'un appareil comportant l'ensemble électronique (10) pour transmettre le résultat de la détermination par le dispositif de sortie (32) à un utilisateur et/ou au dispositif de commande principal (30).

15. Utilisation du procédé selon l'une quelconque des revendications 1 à 8 ou du dispositif selon l'une quelconque des revendications 9 à 14 pour un circuit d'entraînement avec un onduleur pour entraîner un moteur à commutation électronique.
